# EUROPEAN PATENT APPLICATION

(11) **EP 2 555 427 A1**
(43) Date of publication of application: **06.02.2013**
(21) Application number: 12176934.3
(22) Date of filing: 18.07.2012
(51) Int. Cl.: H03J 1/00

(54) **Radio devices with a graphic interface**

(30) Priority: 02.08.2011 IT PN20110057
(71) Applicant: Elad S.r.l., 33070 Sarone di Caneva, Pordenone (IT)
(72) Inventor: Milan, Franco, 33070 Caneva, PORDENONE (IT)
(74) Representative: Mozzi, Matteo

(57) **Abstract**

A tuning system of a radio appliance is described, based on a graphic interface realised by means of a structure composed of two or more bars each of which represents a portion of the entire range of frequencies tunable by the radio device, said system makes it possible to facilitate and potentiate the tuning procedures of radio devices, both of the traditional and SDR (Software Defined Radio) type.

The methods of interaction of the graphic interface with the pointing device, the relations existing between the various bars of the structure and the calculation algorithms permitting updating thereof, are described.

## Description

"Systems and methods to simplify and control the tuning of a radio devices by pointing, clicking and dragging operations within a graphic interface comprising two or more tuning bars wherein the graphic interface can be driven by electronic devices or data stream"

### DESCRIPTION

It is known that the current state of the art permits the manual tuning of a radio, whether of the traditional or SDR (Software Defined Radio) type, by means of the man-machine interaction achieved using input devices and a graphic interface visualised on a viewing device both controlled by a software tuning application, installed on a processing unit. The selection of the desired frequency may take place by typing, extraction from an archive, or the variation of the digits, singly or in groups, which form the numerical value or by using a pointing system.

Fig.1 shows a pointing device (500) connected to a processing unit (520) in turn connected to a viewing device (540).

Figure 2 shows a frequency axis (250) along which a usable range "R" is shown, expressed as a difference between an upper limit (202) and a lower limit (201) of all the frequencies tunable by the receiver.

The state of the art then permits tuning by operation of a pointing system within a graphic interface. In this context only a portion of the entire utilisable tuning range "R" is shown on the viewing device (540) in that the dimensions of said portion depend on multiple factors such as the capacity of the reception circuits of the frequency signal, the calculation capacity of the processing unit (520), the graphic resolution of the viewing device and the desired tuning sensitivity.

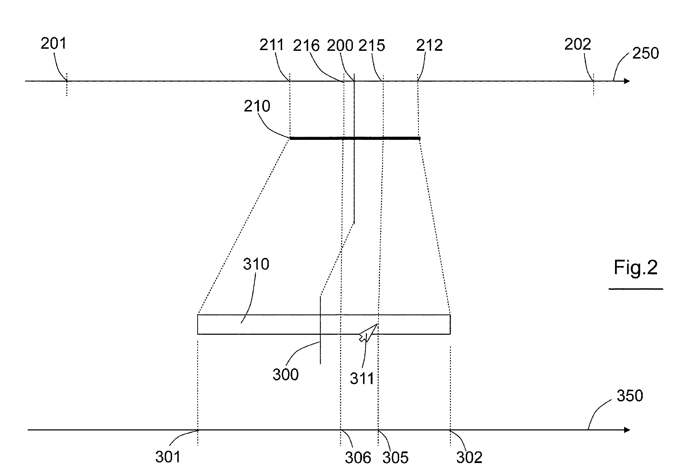

Said frequency portion, shown in Figure 2 by the segment (210) obtained as the difference between the frequencies corresponding to the extremes (212) and (211), is graphically represented on the viewing device (540) by a tuning bar (310) of a length "L" equal to the distance between the position (302) and the position (301) on the horizontal axis (350) of said viewing device (540). The reference (300) within the tuning band (310) represents the tuning point, which corresponds on the frequency axis to the tuning frequency (200) and may coincide more or less with the frequency used for the demodulation of the radio signal received.

The term tuning is taken to mean the set of operations performed by the user so as to tune the radio appliance to a given frequency. Such operations may be aimed both at setting a specific frequency known to the user beforehand, and for tuning an unknown frequency obtained by sequential scrolling through the frequencies within the tuning range "R" until the desired signal is found.

Both the actions just described, moving to a desired frequency or scrolling through the frequencies within a tuning range "R", take place by means of three subsequent steps called "Positioning", "Clicking" and "Dragging". Performance by the user of the aforesaid steps results in the updating, consistent with movement of the pointing system (500), of the extremes (211) and (212) of the frequency portion (210) represented by the tuning bar (310).

In the "Positioning" step a pointer or cursor (311) of the pointing device (500) is positioned inside the tuning bar (310).

The "Clicking" step activates the selection function controlled by the pointing device (500), which determines the position (305) of the pointer (311) on the horizontal axis (350). At this point the processing unit (520) memorises the current position (305) of the pointer (311) and the length "L" of the tuning bar, just as it memorises the frequency values corresponding to said extremes (211) and (212).

During the "Dragging" step the processing unit (520) recalculates the frequency values of said extremes (211) and (212) on the basis of the algebraic value "S" of the horizontal shift of the cursor (311) along the tuning bar (310), compared to the value memorised (305) during the "Clicking" step. "S" assumes a negative value if the cursor (311) moves from the clicking position (305) towards the upper extreme (302) and a positive value if the movement is towards the lower extreme (301).

With reference to figure 2, calling X₃₀₅ the value on the reference axis (350) corresponding to the position (305) memorised during the "Clicking" step and X₃₀₆ the value corresponding to the current position (306) of the pointer (311), "S" assumes a quantity equal to [X₃₀₅-X₃₀₆].

Calling F**₂₁₁** and F**₂₁₂** the values memorised during the "Clicking" step of the frequencies of said extremes (211) and (212), for each horizontal shift "S" the updated values F'**₂₁₁**(S) and F'**₂₁₂**(S) may be obtained respectively equal to F_{'**211**}(S)=[F₂₁₁+ΔF(S)] and F'**₂₁₂**(S)=[F**₂₁₂**+ΔF(S)], where ΔF(S)={[(F**₂₁₂-**F**₂₁₁**)/L]×S} represents the frequency variation relative to the shift "S". Indicating the tuning frequency as F**₂₀₀**, it too will be updated to the value F'**₂₀₀**(S)=[F**₂₀₀**+ΔF(S)].

The method described, used by the current state of the art, is decidedly limited in that it does not permit rapid tuning within the entire range of tunable frequencies "R". This is due to the fact that during the "Dragging" step, the pointing device can only move within the range of frequencies (210) between the extremes (211) and (212), which is significantly less than said range "R" of available frequencies.

The purpose of the present invention is to provide a tuning system which facilitates the tuning procedures of a radio using an innovative graphic multi-bar interface which gives the user a broad view of the tuning possibilities and with consequent increased control compared to the current state of the art.

Such purpose is achieved by a tuning system which overcomes such limitation by using a graphic representation consisting of the simultaneous viewing of several bars, each of which characterised by a different scale factor and therefore able to describe a different portion of frequencies to that of the other bars composing the multi-bar structure. The bars are realised in such a way that they have a common frequency which coincides with the tuning frequency of the radio appliance. Moreover, said bars are correlated with each other so that the "Positioning", "Clicking" and "Dragging" operations performed on one result in a proportional update on the respective scale factors of the remaining bars.

The characteristics of the present invention will be more clearly comprehensible from the description below of a practical embodiment wherein the tuning is performed using a three bar structure, with reference to the appended drawings, wherein:

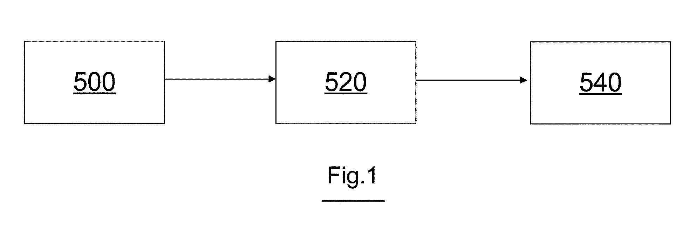

- fig. 1 shows a pointing device connected to a processing unit in turn connected to a viewing device;
- figure 2 shows the frequency axis of the viewing device on which the usable range "R" is shown, expressed as the difference between an upper limit and a lower limit of all the frequencies tunable by the receiver, and

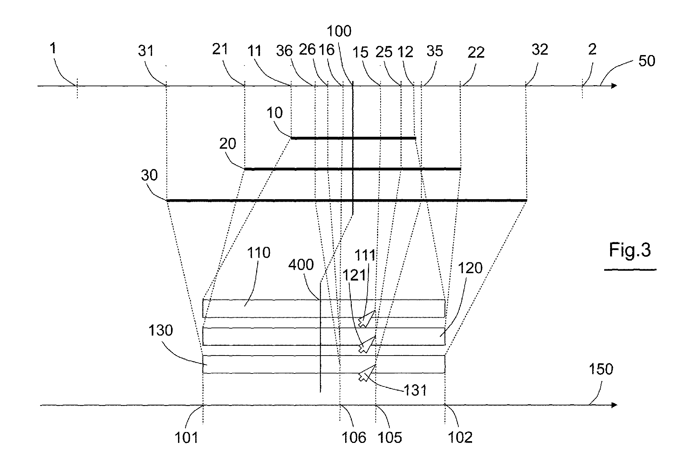

- figure 3 shows a graphic interface of a tuning system according to one embodiment of the present invention.

With reference to fig.3, a graphic interface of a tuning system is composed of two or more (three in the example in figure 3) tuning bars (110), (120) and (130), all of a length "L" equal to the distance between a position (102) and a position (101) on a horizontal axis (150) of a viewing device (540). Said tuning bars (110), (120) and (130) refer respectively to segments (10), (20) and (30) in turn obtained as the difference between frequencies corresponding to the extremes thereof (12) and (11), (22) and (21), (32) and (31). The tuning frequency, corresponding to a reference frequency (100), coincides with the frequency common to said segments (10), (20) and (30) and corresponds to a reference (400) common to the respective bars (110), (120) and (130).

The values relative to the upper (12) and lower (11) limits of the segment (10) are obtained respectively by adding and subtracting the positive quantities ΔF**_{dx10}** and ΔF**ₛₓ₁₀** from the tuning frequency (100). In the same way the values corresponding to the extremes (22), (21), (32) and (31) are obtained by means of the positive offset ΔF**_{dx20}**, ΔF**ₛₓ₂₀**, ΔF**_{dx30}** and ΔF**ₛₓ₃₀**. With reference to the example shown in Fig.3 we have ΔF**_{dx10}**=ΔF**ₛₓ₁₀**, ΔF**_{dx20}**=ΔF**ₛₓ₂₀** e ΔF**_{dx30}**=ΔF**ₛₓ₃₀**. By means of these quantities we can also define the frequency bands covered by the segments (10), (20) and (30) respectively as ΔF**₁₀=**[ΔF**_{dx10}+**ΔF**ₛₓ₁₀**], ΔF**₂₀**=[ΔF**_{dx20}**+ΔF**ₛₓ₂₀**] and ΔF**₃₀**=[ΔF**_{dx30}**+ΔF**ₛₓ₃₀**].

As pointed out above, the tuning bars (110), (120) and (130) are characterised by different scale factors, and this means that the segments (10), (20) and (30) cover different portions of the usable range "R", while continuing to have in common the tuning frequency corresponding to the reference (100).

In the present invention the tuning of the receiver is achieved, in the same way as described for the state of the art, by the "Positioning", "Clicking" and "Dragging" steps described above and performed on the bar deemed most suitable each time for achieving the tuning the frequency in the fastest, most intuitive manner. The difference from what was described earlier consists of the fact that the calculation algorithm which updates the tuning frequency must now take into account the scale factor characterising the bar which the pointer of the pointing device (500) acts on. Once the value of the new tuning frequency has been recalculated, the algorithm consistently updates the extremes of the segments (10), (20) and (30).

In the case, without loss of generality, of operating on the tuning bar (110), "S" indicates the algebraic value of the horizontal shift of the cursor (111) within the tuning bar (110) in relation to the "Clicking" position (105)."S" is given by the quantity [X**₁₀₅**-X**₁₀₆**], where X**₁₀₅** represents the value on the reference axis (150) of the "Clicking" position (105) while X**₁₀₆** is the value corresponding to the current position (106) of the pointer (111).

Calling F**₁₀₀** the tuning frequency memorised during the "Clicking" step for each "S" the updated value F'**₁₀₀**(S)=[F**₁₀₀**+ΔF**₁₁₀**(S)] may be obtained, where ΔF**₁₁₀**(S)={[ΔF**₁₀/**L]XS} represents the variation in frequency associated with the shift "S" on the bar (110).

Considering the scale factors used in the example shown in Figure 3, if the same shift "S" from the position (105) to the position (106) had been performed on the bar (120) a variation in frequency ΔF**₁₂₀**(S)={[ ΔF**₂₀**/L]xS}, with ΔF**₁₂₀**(S)> ΔF**₁₁₀**(S) would have been obtained.

Once the tuning frequency F'**₁₀₀**(S) relative to the shift "S" has been obtained, the algorithm will recalculate the values of the limits of the segments (10), (20) and (30). Calling F'**₁₁**(S), F'**₁₂**(S), F'**₂₁**(S), F'**₂₂**(S), F'**₃₁**(S), and F'**₃₂**(S) the updated frequencies corresponding to (11), (12), (21), (22), (31) and (32), they will respectively assume the values F'**₁₁**(S)=[F'**₁₀₀**(S)-ΔF**ₛₓ₁₀**], F'**₁₂**(S)=[F'**₁₀₀**(S)+ΔF**_{dx10}**], F'**₂₁**(S)=[F'**₁₀₀**(S)-ΔF**ₛₓ₂₀**], F'**₂₂**(S)=[F'**₁₀₀**(S)+ΔF**_{dx20}**], F'**₃₁**(S)=[F'**₁₀₀**(S)-ΔF**ₛₓ₃₀**], F'**₃₂**(S)=[F'**₁₀₀**(S)+ΔF**_{dx30}**].

According to a further embodiment of the tuning system, the tuning bars (110, 120, 130) of the graphic interface may be represented according to any orientation whether horizontal, vertical or oblique.

According to a further embodiment of the tuning system, the tuning bars (110, 120, 130) of the graphic interface may be represented by a curvilinear or circular pattern.

According to a further embodiment of the tuning system, the graphic interface comprises numerical, alpha-numerical values, symbols and icons supporting the tuning operation.

According to a further embodiment of the tuning system, the pointing device (500) may be realised by means of peripheral input devices such as touch screens, remote controls or remote control via data stream.

According to a further embodiment of the tuning system, the limits of the frequency portions of the tuning bar (110, 120, 130) of the graphic interface may be predetermined, that is to say may assume pre-set values which are read by the software application during the initialisation step, or dynamically variable, that is to say modifiable during the execution of such application.

According to a further embodiment of the tuning system, the length of said tuning bars (110, 120,130) of the graphic interface may be predetermined, that is to say may assume pre-set values which are read by the software application during the initialisation step, or dynamically variable, that is to say modifiable during the execution of such application.

According to a further embodiment of the tuning system, said tuning frequency (10) may assume any position within said tuning bars (110,120,130).

According to a further embodiment of the tuning system, the position of said tuning frequency (100) may be predetermined, that is to say a pre-set value which is read by the software application during the initialisation step, or dynamically variable , that is to say modifiable during the execution of such application.

On the basis of the description, by acting on one of the bars composing the graphic interface a fluid overall movement of the entire structure is achieved. The user, interacting therewith by means of the pointing system alone, is thus able to perform frequency shifts extremely different from one another depending on the bar used, thereby achieving rapid and complete control of the radio appliance over the entire range "R" of tunable frequencies.

## Claims

1. Tuning system of a radio appliance, **characterised by** the fact of comprising a graphic interface composed of two or more tuning bars (110, 120, 130) each of which represents a portion of frequencies of the entire range of frequencies tunable by the radio appliance and comprising a tuning frequency (100), said two or more tuning bars (110, 120, 130) being **characterised by** the fact that the shift of a cursor (111, 121, 131) on the graphic interface associated with a pointing device (500) inside one of said two or more tuning bars (110, 120, 130), determines tuning on a new tuning frequency and the recalculation of new frequency limits relative to said two or more tuning bars (110, 120, 130).

2. Tuning system according to claim 1, wherein said two or more tuning bars (110, 120, 130) of the graphic interface may be represented according to any orientation whether horizontal, vertical or oblique.

3. Tuning system according to claim 1, wherein said two or more tuning bars (110, 120, 130) of the graphic interface may be represented by a curvilinear or circular pattern.

4. Tuning system according to any of the previous claims, wherein the graphic interface comprises numerical, alpha-numerical values, symbols and icons supporting the tuning operation.

5. Tuning system according to claim 1, wherein the pointing device (500) may be realised by means of peripheral input devices such as touch screens, remote controls or remote control via data flow.

6. Tuning system according to claim 1, wherein the limits of the frequency portions of said two or more tuning bars (110, 120,130) of the graphic interface, may be predetermined, that is to say may assume pre-set values which are read by the software application during the initialisation step, or dynamically variable, that is to say modifiable during the execution of such application.

7. Tuning system according to claim 1, wherein the length of said two or more tuning bars (110, 120, 130) of the graphic interface may be predetermined, that is to say may assume pre-set values which are read by the software application during the initialisation step, or dynamically variable, that is to say modifiable during the execution of such application.

8. Tuning system according to claim 1, wherein said tuning frequency (10) may assume any position within said two or more tuning bars (110, 120, 130).

9. Tuning system according to claim 8, wherein the position of said tuning frequency (100) may be predetermined, that is to say a pre-set value which is read by the software application during the initialisation step, or dynamically variable, that is to say modifiable during the execution of such application.
